# EUROPÄISCHE PATENTANMELDUNG

(11) **EP 3 599 242 A1**
(43) Veröffentlichungstag der Anmeldung: **29.01.2020**
(21) Anmeldenummer: 18186140.2
(22) Anmeldetag: 27.07.2018
(51) Int. Cl.: C07F 15/06, H01L 21/205, C23C 16/18

(54) **METALLORGANISCHE VERBINDUNGEN**

(71) Anmelder: UMICORE AG & CO. KG, 63457 Hanau-Wolfgang (DE)
(72) Erfinder: SCHORN, Wolf, 76337 Waldbronn (DE); FREY, Annika, 63457 Hanau (DE); WOERNER, Eileen, 61130 Nidderau (DE); DOPPIU, Angelino, 63500 Seligenstadt (DE); KARCH, Ralf, 63801 Kleinostheim (DE)

(57) **Zusammenfassung**

Die vorliegende Patentanmeldung betrifft neuartige Allylcobaltkomplexe, ein Verfahren zur ihrer Herstellung und ihre Verwendung zur Gasphasenabscheidung.

## Beschreibung

Allyl-Cobaltkomplexe der allgemeinen Formel [CO(η³-C₃H₄-R1)(CO)₃] bzw. [CO(η³-Allyl-R1)(CO)₃], insbesondere [Co(η³-C₃H₅)(CO)₃] sowie Verfahren zu deren Herstellung haben in der jüngeren Vergangenheit verstärktes Interesse gefunden.

Chatani et al., Tetrahedron Letters 24, (1983), 5649-5652 zeigt eine Synthese von (η³-Allyl)Co(CO)₃ durch Reaktion von Cobaltoctacarbonyl Co₂(CO)₈ mit Trimethylsilan und anschließender Umsetzung mit Allylacetat in Benzol als Lösemittel. Chatani gibt die Ausbeuten für die erste Stufe mit 85% an, die auf Allylacetat bezogene Ausbeute der zweiten Stufe mit 52%. Bei der Optimierung dieser Synthese wurde gefunden, dass die auf Cobalt bezogene Gesamtausbeute dieses Verfahrens über beide Stufen maximal 25% betrug.

KR 101587509 beschreibt eine Synthese von (η³-Allyl)Co(CO)₃ durch Reaktion von Cobaltoctacarbonyl Co₂(CO)₈ in etherischer Lösung mit wäßriger Natronlauge in Gegenwart von Benzyltriethylammoniumchlorid als Phasentransferkatalysator und anschließender Zugabe von Allylbromid. Die organische Phase wird dann abgetrennt, getrocknet und das Reaktionsprodukt nach Entfernung des Lösemittels destillativ gereinigt, wobei das Reaktionsprodukt in einer auf Cobalt bezogenen Gesamtausbeute über beide Stufen von 38% erhalten wurde.

Es war die Aufgabe der Erfindung, ein Verfahren zur Herstellung von Allyl-Cobaltkomplexen der allgemeinen Formel [Co(η³-C₃H₄-R1)(CO)₃] bzw. [CO(η³-Allyl-R1)(CO)₃], insbesondere [CO(η³-C₃H₅)(CO)₃], bereitzustellen, welches verbesserte Ausbeuten ermöglicht.

Es wurde überraschend gefunden, dass diese Aufgabe gelöst wird von einem Verfahren zur Herstellung von Allyl-Cobaltkomplexen der allgemeinen Formel [CO(η³-C₃H₄-R1)(CO)₃] bzw. [CO(η³-Allyl-R1)(CO)₃] enthaltend die Schritte
a. Reaktion von Cobaltoctacarbonyl Co₂(CO)₈ mit einem Trialkylhydrosilan der Formel (R2)₃Si-H zu einem Cobaltkomplex der allgemeinen Formel (R₂)₃Si-Co(CO)₄];
b. Reaktion des so erhaltenen Cobaltkomplexes der allgemeinen Formel (R₂)₃Si-Co(CO)₄] mit einem organischen Ester der allgemeinen Formel R3-(CO₂-Allyl-R1)ₓ mit X=1, 2 oder 3 zum Cobaltkomplex [CO(η³-C₃H₄-R1)(CO)₃].

In einem optionalen Schritt c. kann das Reaktionsprodukt, der Allyl-Cobaltkomplex der allgemeinen Formel [Co(η³-C₃H₄-R1)(CO)₃] bzw. [Co(η³-Allyl-R1)(CO)₃], aus dem Reaktionsgemisch entfernt werden, insbesondere durch Destillation. Dabei ist es von Vorteil, dass keine fraktionierte Destillation erforderlich und damit eine sehr einfache Abtrennung des Reaktionsprodukts möglich ist.

R1 und R2 bedeuten unabhängig voneinander Wasserstoff oder Alkyl.

R1 kann dabei insbesondere Wasserstoff, C1 bis C5-Alkyl und C1 bis C5-Cycloalkyl bedeuten und ist insbesondere ausgewählt aus der Gruppe bestehend aus H, Methyl, Ethyl, n-Propyl, iso-Propyl, n-Butyl, tert.-Butyl, Cyclobutyl und deren Kombinationen.

R2 kann dabei insbesondere Wasserstoff und C1 bis C5-Alkyl bedeuten und ist insbesondere ausgewählt aus der Gruppe bestehend aus H, Methyl, Ethyl, n-Propyl, iso-Propyl, n-Butyl und deren Kombinationen.

R3 ist Alkyl, Cycloalkyl oder Aryl und kann insbesondere ein C3 bis C10-Alkyl, Cycloalkyl oder Aryl sein, welches mit einem C1 bis C8-Alkyl oder Cycloalkyl substituiert oder kondensiert sein kann. Insbesondere kann R3 ausgewählt sein aus Hexyl, Heptyl, Octyl, Cyclohexyl, Cyclooctyl, Phenyl, 4-Toluyl, 2-Cyclohexylethyl oder deren Kombinationen.

Der organische Ester der allgemeinen Formel R3-(CO₂-Allyl-R1)ₓ kann eine Verbindung mit X= 1, 2 oder 3 sein. Insbesondere kann X gleich 1 oder 2 sein. Insbesondere kann X gleich 2 oder 3, vorteilhaft 2 sein, wenn R3 ein Aromat oder Cycloalkyl ist. Ist R3 Alkyl, dann ist X vorteilhaft 1. In einer spezifischen Ausgestaltung ist der organische Ester der allgemeinen Formel R3-(CO₂-Allyl-R1)ₓ ein Heptanoat des Typs C₆H₁₃CO₂-Allyl-R1, wobei R1 wie oben definiert ist, insbesondere mit R1 = H, Methyl, Ethyl, iso-Propyl oder tert-Butyl.

In Schritt a. hat es sich bewährt, wenn Cobaltoctacarbonyl Co₂(CO)₈ vorgelegt und das Trialkylhydrosilan der Formel (R2)₃Si-H allmählich zugegeben wird, wobei sich mit Triethylhydrosilan, also eine Verbindung, in der R2 Ethyl ist, gute Ergebnisse erzielen lassen. Da es sich um eine exotherme Reaktion handelt, kann die Reaktionstemperatur auch, aber nicht nur, durch die Zugabegeschwindigkeit des Trialkylhydrosilans kontrolliert werden.

Das Trialkylhydrosilan kann im Verhältnis zum Cobaltoctacarbonyl Co₂(CO)₈ äquimolar vorgelegt werden. Gute Ergebnisse wurden mit einem leichten Überschuss von 1,01 bis 1,3, insbesondere 1,02 bis 1,2 oder 1,04 bis 1,1 Äquivalenten Trialkylhydrosilan, insbesondere Triethylhydrosilan erzielt. Die Ausbeuten bei dieser Stufe liegen meist bei 95 bis 98%.

Als Lösemittel kommen im Allgemeinen verzweigte oder unverzweigte Alkane, Ether oder Aromaten, insbesondere solche mit 5 bis 10 Kohlenstoffatomen in Frage. Dies umfasst beispielsweise Lösemittel wie Pentan, Hexan, Heptan, Oktan, Benzen, Toluen, Diethylether, Diisopropylether, Tetrahydrofuran, Dioxan oder deren Kombinationen. Gute Ergebnisse lassen sich insbesondere mit Heptan erzielen.

Die Reaktionstemperatur liegt im Allgemeinen bei Raumtemperatur, also etwa 15°C bis 55°C oder 20°C bis 40°C, insbesondere 20 bis 25°C. Die Zugabegeschwindigkeit und damit auch die Reaktionzeit hängen damit von der gewünschten Reaktionstemperatur ab. Im Allgemeinen geeignet sind Zeiten von zwei bis acht, insbesondere 3 bis 5 Stunden oder von 2,5 bis 4,5 Stunden.

Anschließend kann das Reaktionsgemisch bei einer Temperatur von etwa 15°C bis 30°C, insbesondere 20 bis 25°C gehalten, welche höher, niedriger oder aber gleich der Reaktionstemperatur sein kann. Bei dieser Temperatur kann 6 bis 24 Stunden, insbesondere 8 bis 18 Stunden oder 6 bis 12 Stunden nachgerührt werden. Das Ende der Reaktion kann leicht daran erkannt werden, dass keine Gasentwicklung mehr erfolgt.

Anschließend kann das Lösemittel und gegebenenfalls überschüssiges Silan entfernt werden. Dies kann beispielsweise durch Destillation erreicht werden, wobei gegebenenfalls ein geeigneter Unterdruck angelegt werden kann, um eine Destillation bei niedrigeren Temperaturen zu ermöglichen. Meist ist bei der Destillation ein Druck von weniger als 100 mbar ausreichend, bewährt haben sich Drücke im Bereich von 15 bis 70 mbar oder 25 bis 50 mbar. Als Temperaturen haben sich im Allgemeinen 30°C bis 70°C, insbesondere 40°C bis 50°C bewährt.

Die Temperaturen und Drücke ergeben sich für den Fachmann aus dem Siedepunkt der abzudestillierenden Substanzen und der gewünschten Temperatur, um eine schonende Stofftrennung zu erreichen. Der so erhaltene Cobaltkomplex der allgemeinen Formel (R2)₃Si-Co(CO)₄] kann dann im folgenden Verfahrensschritt weiter umgesetzt werden.

In Schritt b. erfolgt die Umsetzung des so erhaltene Cobaltkomplexes der allgemeinen Formel [(R2)₃Si-Co(CO)₄] mit einem organischen Ester der allgemeinen Formel R3-(CO₂-Allyl-R1)ₓ mit X=1, 2 oder 3, wobei R1 und R3 definiert sind wie oben beschrieben.

Der organischen Ester der allgemeinen Formel R3-(CO₂-Allyl-R1)ₓ wird vorzugsweise mindestens äquimolar zum Cobaltkomplex der allgemeinen Formel (R2)₃Si-Co(CO)₄] eingesetzt, kann aber auch im Überschuß eingesetzt werden, wobei ein 1,1 bis doppelter molarer Überschuß ausreichen und ein noch größerer Überschuß unschädlich sind.

Bei der Reaktion kann ein Lösemittel verwendet wird, das einen Siedepunkt von mehr als etwa 200°C bei Normaldruck aufweist. Gute Ergebnisse lassen sich beispielsweise mit langkettigen aliphatischen Kohlenwasserstoffen erzielen, insbesondere mit verzweigten oder unverzweigten Alkanen mit mehr als 14 Kohlenstoffatomen, wobei sich meist solche mit 19 Kohlenstoffatomen oder weniger bewährt haben. Geeignete Lösemittel sind beispielsweise Tetradecan, Pentadecan, Hexadecan, Heptadecan, Octadecan, Nonadecan, aber auch Alkane mit mehr als 19 Kohlenstoffatomen, wie zum Beispiel bis 34 Kohlenstoffatomen, können verwendet werden, insbesondere dann, wenn diese bei Raumtemperatur oder zumindest bei der Reaktionstemperatur flüssig sind, wie zum Beispiel Botrycoccan und 2,6,10,15,19,23-Hexamethyltetracosan (Squalan). Geeignete Lösemittel sind daher insbesondere beispielsweise Tetradecan, Pentadecan, Hexadecan, Heptadecan, Octadecan, Nonadecan, Botrycoccan, 2,6,10,15,19,23-Hexamethyltetracosan (Squalan)und deren Kombinationen.

In einer spezifischen Ausgestaltung kann auch der organische Ester der allgemeinen Formel R3-(CO₂-Allyl-R1)ₓ als Lösemittel eingesetzt werden, sofern dieser einen Siedepunkt von mehr als etwa 200°C aufweist. Hierbei hat sich insbesondere das Heptanoat des Typs C₆H₁₃CO₂-Allyl-R1 bewährt, insbesondere kann R1 C1 bis C5-Alkyl und C3 bis C5-Cycloalkyl bedeuten und ist insbesondere ausgewählt aus der Gruppe bestehend aus H, Methyl, Ethyl, n-Propyl, iso-Propyl, n-Butyl, tert.-Butyl, Cyclobutyl und deren Kombinationen.

Die Zugabereihenfolge der Edukte, des Cobaltkomplexes der allgemeinen Formel (R2)₃Si-Co(CO)₄] und des organischen Esters der allgemeinen Formel R3-(CO₂-Allyl-R1)ₓ, ist im Prinzip unkritisch. Es hat sich bewährt, den Cobaltkomplex vorzulegen, gegebenenfalls das Lösemittel zuzugeben und nach einer eventuellen Nachrührzeit, bis sich der Cobaltkomplex gelöst oder sich eine homogene Suspension gebildet hat, den organischen Ester allmählich zuzugeben. Die Reaktionstemperatur beträgt etwa 20°C bis 90°C, insbesondere 40°C bis 80°C oder 60°C bis 80°C. Gute Ergebnisse lassen sich mit 65°C bis 75°C erreichen. Da die Reaktion exotherm ist, kann die Aufheizung durch Zugabe des Esters der allgemeinen Formel R3-(CO₂-Allyl-R1)ₓ erfolgen, jedoch kann durch Vorheizen auf die Reaktionstemperatur die Durchführung des Verfahrens beschleunigt werden. Die Zugabegeschwindigkeit kann dann so gewählt werden, dass die Reaktionstemperatur nicht übermäßig schwankt, beispielsweise um nicht mehr als ±5°C, oder die Temperatur wird durch Erwärmen im Wesentlichen konstant gehalten. Ist die Zugabe abgeschlossen, so kann zur Vervollständigung der Reaktion die Reaktionstemperatur gehalten und nachgerührt werden, wobei im Allgemeinen nicht mehr als 1 bis 8 Stunden, insbesondere 1,5 bis 5 oder 2 bis 4 Stunden ausreichen. Das Ende der Reaktion kann leicht daran erkannt werden, dass keine Gasentwicklung mehr erfolgt. Da in diesem Schritt das erwünschte Reaktionsprodukt die am leichtesten flüchtige Verbindung ist, wird dieses einfach abdestilliert. Im Allgemeinen haben sich Destillationstemperaturen von 60°C bis 100°C bei einem Druck von weniger als 25 mbar bewährt. Gute Ergebnisse lassen sich bei Temperaturen von 60°C bis 80°C und einem Druck von weniger als 10 bar erzielen, wobei gegebenenfalls bei konstanter Temperatur der Druck sukzessive abgesenkt werden kann. Die Vorlage kann auf Temperaturen von weniger als 60°C gekühlt werden, wie zum Beispiel aus 15°C bis 50°C oder von 20°C bis 45°C.

Das Verfahren zur Herstellung von Allyl-Cobaltkomplexen der allgemeinen Formel [Co(η³-C₃H₄-R1)(CO)₃] bzw. [Co(η³-Allyl-R1)(CO)₃] kann auch als Ein-Topf-Reaktion durchgeführt werden. Hierzu können nach Abschluss des Schritts a. das Lösemittel und überschüssiges Trialkylhydrosilan abdestilliert werden und anschließend das Lösemittel des Schritts b. sowie der organische Ester der allgemeinen Formel R3-(CO₂-Allyl-R1)ₓ zugegeben werden.

In einer vereinfachten Ausgestaltung dieser Ausführungsform wird auf das Abdestillieren des Lösemittels und überschüssigen Trialkylhydrosilans verzichtet und stattdessen der organische Ester der allgemeinen Formel R3-(CO₂-Allyl-R1)ₓ sowie gegebenenfalls das Lösemittel zugegeben. Generell ist es vorteilhaft, besonders aber bei dieser Verfahrensführung, wenn als Lösemittel der organische Ester der allgemeinen Formel R3-(CO₂-Allyl-R1)ₓ verwendet wird. Da sich nach Abschluß des Schritts b. bei dieser Verfahrensvariante noch immer überschüssiges Trialkylhydrosilan sowie das Lösemittel aus Schritt 1 im Reaktionsgemisch befinden, ist je nach dem Siedepunkt des Endproduktes eine fraktionierte Destillation erforderlich. Dem gegenüber kann bei Isolation des Produktes von Schritt a. oder zumindest nach Abdestillieren von Lösemittel und Trialkylhydrosilan nach Abschluss von Schritt a. auf eine fraktionierte Destillation nach Abschluss von Schritt b. oft verzichtet und das Endprodukt durch eine einfache Destillation gewonnen werden.

### Beispiele

### Schritt a.

In einem 4-Liter-4-Hals-Glaskolben, ausgestattet mit einem KPG-Rührer, einem Temperaturfühler zur Kontrolle der Innentemperatur, einem Tropftrichter ohne Gasausgleich sowie einem Intensivkühler mit Überdruckventil werden 638 g Dicobaltoctacarbonyl (1,86 mol, 1.00 eq.) vorgelegt und mit 1,00 Liter Heptan aufgeschlämmt. Der Reaktionskolben wird mit einem Wasserbad auf 20±4°C gehalten. Das Reaktionsgemisch wird mit 300 U/min gerührt. Anschließend werden 467 g Triethylsilan (4,02 mol, 2.15 eq.) innerhalb von vier Stunden hinzugetropft, dabei wird darauf geachtet, dass die Innentemperatur im Bereich von 20±4°C liegt. Nach beendeter Zugabe wird das Triethylsilangebinde wird mit 100 mL Heptan gespült und das Heptan/Triethylsilan-Gemisch zum Reaktionsgemisch gegeben. Das Reaktionsgemisch wird bei Raumtemperatur über Nacht gerührt. Am nächsten Tag wird aus dem Reaktionsgemisch bei 50°C Innentemperatur und einem Druck von 30 mbar das Lösungsmittel Heptan sowie überschüssiges Triethylsilan abdestilliert. Wenn der Destillatstrom zu versiegen beginnt, wird der Druck sukzessive reduziert bis zu einem Enddruck von 18 mbar. Das Produkt verbleibt im Reaktionskolben. Isoliert: 1095 g.

Das Produkt kann einem Reinigungsschritt unterworfen werden:
Dafür wird das Produkt im dynamischen Vakuum umkondensiert. Die Innentemperatur beträgt 50°C, die Vorlage wird mit 0°C gekühlt, das Vakuum beträgt <1*10-3 mbar. 573 g Rohprodukt ergeben dabei 534 g gereinigtes Material.

### Schritt b.

400 g gereinigtes Triethylsilylcobalttetracarbonyl (1,40 mol, 1,00 eq.) wird in einem 4-Liter-4-Hals-Glaskolben, ausgestattet mit Magnetrührkern, einem Intensivkühler mit Überdruckventil, einem Tropftrichter ohne Gasausgleich, einem Temperaturfühler zur Kontrolle der Innentemperatur und einer Destillationskolonne in Kombination mit einer Destillierbrücke und einer Vorlage, vorgelegt. Über die Vorlage kann das System inertisiert und auch evakuiert werden. Der Intensivkühler sowie die Destaillationsbrücke werden auf -10°C gekühlt. Für den ersten Teil der Reaktion wird das freiwerdende Gas über den Intensivkühler mit Überdruckventil abgelassen. Das Reaktionsgemisch wird bei 300 U/min gerührt, auf 70°C Innentemperatur erhitzt und bei dieser Temperatur werden tropfenweise 263 g Allylheptanoat (1,54 mol, 1,10 eq.) hinzugegeben. Dies erfolgt innerhalb von 70 Minuten, dabei wird die Zutropfrate so angepasst, dass die Innentemperatur bei 70±5°C bleibt. Nach beendeter Zugabe wird das Reaktionsgemisch noch drei Stunden bei 70°C nachgerührt, bis keine Gasentwicklung mehr zu beobachten ist. Der zweite Teil der Reaktion besteht aus der Destillation des Rohproduktes. Die Vorlage wird auf ca. -40°C gekühlt und unter Rühren bei 300 U/min wird über die Vorlage bei einer Sumpftemperatur von 70°C langsam Vakuum auf die Apparatur gegeben. Bei einem Druck von 29 mbar beginnt das Produkt zu destillieren. Wenn der Destillatstrom zu versiegen neigt, wird der Druck sukzessive auf 7 mbar reduziert. Es werden 236 g des Rohproduktes (1,29 mol, 92%) erhalten mit einer Reinheit von 99 m%.

Das Rohprodukt kann durch eine Feindestillation gereinigt werden:
Die Destillation bei einer Innentemperatur von 40°C und einem Druck von 10 mbar über eine Vigreux-Kolonne liefert 92% eines Produktes, das eine Reinheit von >99m% AllyCoCO aufweist.

## Patentansprüche

1. Verfahren zur Herstellung von Allyl-Cobaltkomplexen der allgemeinen Formel [Co(η³-C₃H₄-R1)(CO)₃] bzw. [Co(η³-Allyl-R1)(CO)₃] enthaltend die Schritte
a. Reaktion von Cobaltoctacarbonyl Co₂(CO)₈ mit einem Trialkylhydrosilan der Form (R2)₃Si-H zu einem Cobaltkomplex der allgemeinen Formel (R2)₃Si-Co(CO)₄];
b. Reaktion des so erhaltenen Cobaltkomplexes der allgemeinen Formel (R2)₃Si-Co(CO)₄] mit einem organischen Ester der allgemeinen Formel R3-(CO₂-Allyl-R1)ₓ mit X=1, 2 oder 3 zum Cobaltkomplex [Co(η³-C₃H₄-R1)(CO)₃], wobei R1 und R2 unabhängig voneinander Wasserstoff oder Alkyl bedeuten und R3 Alkyl, Cycloalkyl oder Aryl ist.

2. Verfahren nach Anspruch 1, wobei R1 ausgewählt ist aus der Gruppe bestehend aus H, Methyl, Ethyl, n-Propyl, iso-propyl, n-Butyl, tert.-Butyl, Cyclobutyl und deren Kombinationen.

3. Verfahren nach Anspruch 1 oder 2, wobei R2 ausgewählt ist aus der Gruppe bestehend aus H, Methyl, Ethyl, n-Propyl, iso-propyl, n-Butyl und deren Kombinationen.

4. Verfahren nach einem oder mehreren der vorstehenden Ansprüche, wobei R3 ein C3 bis C10-Alkyl, Cycloalkyl oder Aryl ist, welches mit einem C1 bis C8-Alkyl oder Cycloalkyl substituiert oder kondensiert sein kann.

5. Verfahren nach einem oder mehreren der vorstehenden Ansprüche, wobei R3 ausgewählt ist aus Hexyl, Heptyl, Octyl, Cyclohexyl, Cyclooctyl, Phenyl, 2-Cyclohexylethyl oder deren Kombinationen.

6. Verfahren nach einem oder mehreren der vorstehenden Ansprüche, wobei der organische Ester der allgemeinen Formel R3-(CO₂-Allyl-R1)ₓ ein Heptanoat des Typs C₆H₁₃CO₂-Allyl-R1 ist.

7. Verfahren nach einem oder mehreren der vorstehenden Ansprüche, wobei in Schritt b. ein Lösemittel verwendet wird, das einen Siedepunkt von mehr als 200°C bei Normaldruck aufweist.

8. Verfahren nach einem oder mehreren der vorstehenden Ansprüche, wobei als Lösemittel, das einen Siedepunkt von mehr als 200°C bei Normaldruck aufweist, der organische Ester der allgemeinen Formel R3-(CO₂-Allyl-R1)ₓ oder Squalan verwendet wird.

9. Verfahren nach einem oder mehreren der vorstehenden Ansprüche, wobei die Reaktionstemperatur in Schritt a. zwischen 20°C und 55°C, oder zwischen 25°C und 30°C liegt.

10. Verfahren nach einem oder mehreren der vorstehenden Ansprüche, wobei in Schritt a. als Lösemittel verzweigte oder unverzweigte Alkane, Ether oder Aromaten mit 5 bis 10 Kohlenstoffatomen verwendet werden.

11. Verfahren nach einem oder mehreren der vorstehenden Ansprüche, wobei in Schritt a. als Lösemittel Pentan, Hexan, Heptan, Oktan, Benzen, Toluen, Diethylether, Diisopropylether, Tetrahydrofuran, Dioxan oder deren Kombinationen verwendet werden.

12. Verfahren nach einem oder mehreren der vorstehenden Ansprüche, wobei der Cobaltkomplex [CO(η³-C₃H₄-R1)(CO)₃] in einem Ein-Topf-Verfahren hergestellt wird.

13. Verfahren nach einem oder mehreren der vorstehenden Ansprüche, wobei der Cobaltkomplex [Co(η³-C₃H₄-R1)(CO)₃] in einem Ein-Topf-Verfahren hergestellt, in Schritt a. ein Lösemittel verwendet und dieses vor Durchführung des Schrittes b. entfernt wird.

14. Verfahren nach einem oder mehreren der vorstehenden Ansprüche, wobei in einem Schritt c. der Cobaltkomplex [CO(η³-C₃H₄-R1)(CO)₃] aus dem Reaktionsgemisch entfernt wird.

15. Verfahren nach einem oder mehreren der vorstehenden Ansprüche, wobei in einem Schritt c. der Cobaltkomplex [CO(η³-C₃H₄-R1)(CO)₃] destillativ aus dem Reaktionsgemisch entfernt wird.

16. Verfahren zur Gasphasenabscheidung von cobalthaltigen Schichten enthaltend die Schritte
- Bereitstellen von Allyl-Cobaltkomplexen der allgemeinen Formel [Co(η³-C₃H₄-R1)(CO)₃] bzw. [Co(η³-Allyl-R1)(CO)₃] nach einem oder mehreren der vorstehenden Ansprüche;
- Einsetzen der Allyl-Cobaltkomplexe der allgemeinen Formel [Co(η³-C₃H₄-R1)(CO)₃] bzw. [Co(η³-Allyl-R1)(CO)₃] in einem Verfahren zur Gasphasenabscheidung von cobalthaltigen Schichten.

17. Verfahren nach Anspruch 16, wobei die Abscheidung durch thermische Zersetzung erfolgt.

18. Verfahren nach Anspruch 16 oder 17, wobei es sich um ein ALD- (Atomic Layer Deposition)oder CVD- (Chemical Vapor Deposition) Verfahren handelt.
